# FASCICULE DE BREVET EUROPEEN

(11) **EP 3 179 533 B1**
(45) Date de publication et mention de la délivrance du brevet: **28.08.2019**
(21) Numéro de dépôt: 15199647.7
(22) Date de dépôt: 11.12.2015
(51) Int. Cl.: H01M 2/10, G04C 3/00, G04C 10/00

(54) **APPAREIL ÉLECTRONIQUE PORTABLE MUNI D'UNE ENCEINTE DE PILE**
TRAGBARES ELEKTRONISCHES GERÄT, DAS MIT EINEM BATTERIEFACH AUSGESTATTET IST
PORTABLE ELECTRONIC APPARATUS PROVIDED WITH A BATTERY COMPARTMENT

(43) Date de publication de la demande: 14.06.2017
(73) Titulaire: ETA SA Manufacture Horlogère Suisse, 2540 Grenchen (CH)
(72) Inventeur: Lagorgette, Pascal, 2502 Bienne (CH); Zanesco, Vittorio, 2000 Neuchâtel (CH); Balmer, Raphaël, 2824 Vicques (CH)
(74) Mandataire: ICB SA

(56) Documents cités:
- EP-A1- 1 184 750
- EP-A2- 0 961 356
- CH-A2- 706 353
- US-A- 3 945 193
- US-A1- 2004 121 226
- US-B1- 7 059 894

## Description

### Domaine de l'invention

L'invention se rapporte au domaine de l'horlogerie, et en particulier le domaine des montres comportant au moins un circuit électronique ou électrique alimenté par un accumulateur tel qu'une pile ou similaire. L'invention concerne plus particulièrement un appareil électronique portable muni d'une enceinte de pile standard.

### Arrière-plan de l'invention

L'état de la technique comprend de nombreux documents relatifs à des dispositifs de montage de pile.

La demande de brevet EP 0 961 356 décrit un support de batterie comprenant un boîtier ayant des parois de retenue situées aux deux extrémités du boîtier et des contacts électriques fixés dans les parois de retenue. Le contact électrique comporte des bras de contact élastiques disposés des deux côtés de la section de base du boîtier. Des sections d'extrémité avant des bras de contact ont des éléments de retenue placés des deux côtés des points diamétralement opposés de la batterie, ce qui empêche la batterie de se détacher et limiter le mouvement de la batterie par rapport à la base.

La demande de brevet internationale WO 01/77760 A1 décrit un dispositif de montage d'une pile-bouton dans le boîtier d'une montre électronique. Ce dispositif comporte notamment un logement, sensiblement cylindrique, moulé à partir de matière plastique et ouvert sur la face arrière de la montre. Le logement comprend, à sa périphérie, des languettes s'étendant depuis le fond en direction de l'ouverture et préférablement moulées d'une pièce avec le logement. Chaque languette est prévue pour former une zone d'appui sur la face de la pile orientée du côté de l'ouverture, lorsque la pile est montée dans le logement. Le montage est effectué par déformation élastique des languettes.

Toutefois, cette structure particulière comporte un inconvénient en ce que pour introduire une pile dans le logement, celle-ci doit être présentée de biais à travers l'ouverture du logement. Ainsi, une telle introduction est délicate à mettre en oeuvre sur une chaîne de montage automatisée.

Un tel dispositif présente également pour inconvénient un risque de défaut du maintien de la pile en cas de choc. En effet, si le choc est suffisamment violent, la pile qui présente une masse relativement importante comparativement aux éléments constitutifs de la montre, peut être projetée dans une direction telle qu'elle peut déformer les languettes élastiques et s'extraire du logement, ce qui peut induire un risque de rupture de l'alimentation électrique de la montre.

Encore un autre inconvénient d'un tel dispositif est que lorsque le diamètre du calibre ou la hauteur de la pile change, le logement plastique doit être adapté et un nouveau moule commandé, ce qui implique des coûts de développements et d'outillage supplémentaires pour chaque nouveau modèle.

### Résumé de l'invention

L'invention a notamment pour objectif de pallier les différents inconvénients de ces techniques connues.

Plus précisément, un objectif de l'invention est de fournir un appareil électronique portable muni d'une enceinte de pile présentant un bon maintien de la pile dans son logement.

L'invention a également pour objectif, au moins dans un mode de réalisation particulier, de fournir un appareil électronique portable muni d'une enceinte de pile qui soit simple et peu coûteuse à mettre en oeuvre.

Encore un autre objectif de l'invention est de fournir une enceinte de pile compatible avec plusieurs épaisseurs de pile, différents mouvements d'un appareil électronique portable, et différentes positions angulaires du mouvement.

Ces objectifs, ainsi que d'autres qui apparaîtront plus clairement par la suite, sont atteints selon l'invention à l'aide d'un appareil électronique portable comprenant au moins un module électronique, le module électronique comportant notamment une platine munie d'une cavité agencée pour recevoir une source d'énergie électrique, au moins un mouvement associé à un circuit imprimé, un organe de contact déformable élastiquement pour assurer une liaison électrique entre la source d'énergie électrique et le circuit imprimé, et des moyens de maintien de la source d'énergie électrique.

Selon l'invention, les moyens de maintien de la source d'énergie électrique comprennent :
- une cage amovible en matière isolante comprenant un fond et une paroi, la cage étant agencée pour recevoir la source d'énergie électrique et comprenant une bride amovible pour maintenir la source d'énergie électrique en place, la cage étant configurée pour être insérée dans la cavité,
- un ressort pour assurer une liaison électrique entre le circuit imprimé et la bride, et
- des moyens de fixation pour fixer de manière amovible la cage au module.

Ainsi, l'objet de la présente invention, par ses différents aspects fonctionnels et structurels décrits ci-dessus, permet d'obtenir un appareil électronique portable pouvant recevoir différentes tailles de calibre et/ou différente taille de pile sans se soucier du bon maintien de la pile.

Conformément à d'autres variantes avantageuses de l'invention :
- la bride comprend une partie centrale s'étendant sur le fond de la cage et une partie latérale s'étendant sur une partie de la paroi circulaire, la partie centrale et la partie latérale comprenant chacune au moins une lame ressort pour exercer respectivement un effort axial et un effort radial sur la source d'énergie électrique ;
- la paroi de la cage présente un logement s'étendant sur tout ou partie de la hauteur de la cage et qui est agencé pour recevoir le ressort, le ressort dépassant de part et d'autre du logement ;
- la bride comprend une languette agencée pour être insérée dans une ouverture à proximité immédiate du fond de la cage et débouchant au niveau du logement de manière que le ressort soit en contact avec la languette et le circuit imprimé ;
- la bride est clippée dans la cage ;
- les moyens de fixation de la cage au module comprennent des pattes de fixation coopérant avec des moyens de vissage ;
- la cage est réalisée en matière plastique ;
- l'organe de contact est en contact avec le pôle négatif et la bride est en contact avec le pôle positif.

### Description sommaire des dessins

D'autres caractéristiques et avantages de l'invention apparaîtront plus clairement à la lecture de la description suivante d'un mode de réalisation particulier de l'invention, donné à titre de simple exemple illustratif et non limitatif, et des figures annexées, parmi lesquelles :
- la figure 1 est une vue en perspective d'un module électronique d'un appareil électronique portable conforme à l'invention ;
- les figures 2 à 5 sont des vues en perspective des moyens de maintien de la source d'énergie électrique conformes à l'invention.

### Description détaillée des modes de réalisation préférés

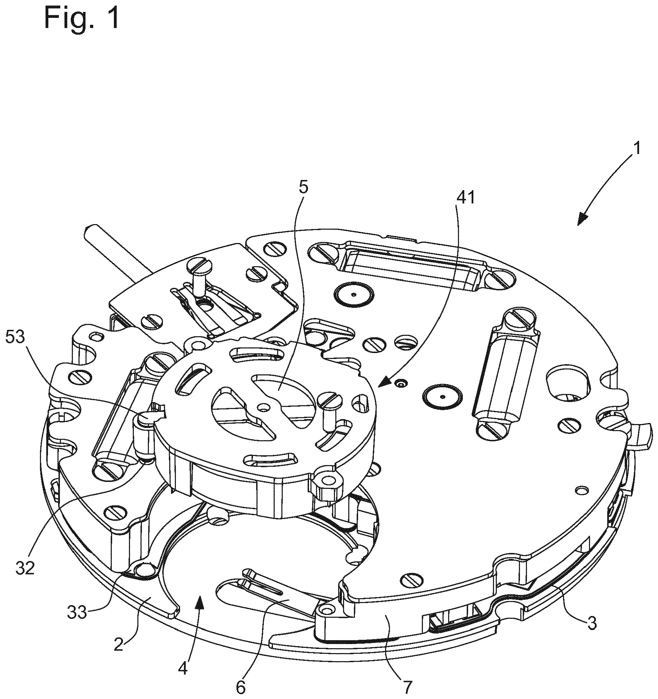

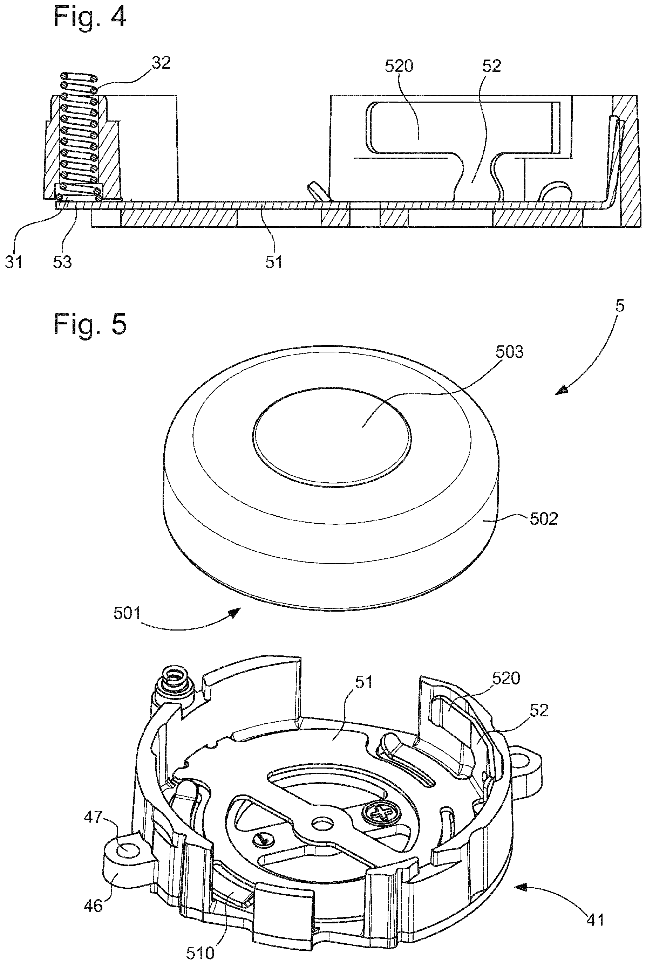

Un appareil électronique portable selon un mode de réalisation particulier va maintenant être décrit dans ce qui suit faisant référence conjointement aux figures 1 à 5.

L'invention concerne un appareil électronique portable de pièce d'horlogerie, notamment une montre, comportant au moins une carrure et un fond (non représentés sur les figures) pour renfermer un module 1 électronique ou électrique. Ce module 1 comporte une platine 2 présentant une cavité 4 qui est agencée recevoir une source d'énergie électrique 5, telle qu'une pile bouton. Ce module 1 comporte également au moins un mouvement 7 associé à un circuit imprimé 3 avec au moins un organe de contact 6 pour assurer une liaison électrique entre la source d'énergie électrique 5 et le circuit imprimé 6.

Dans une version préférée mais non limitative de l'invention, l'organe de contact 6 est déformable élastiquement et est réalisé sous la forme d'une lame ressort.

Tel que visible sur la figure 1, l'organe de contact 6 est agencé pour prendre appui sur la source d'énergie électrique 5 lorsqu'elle est placée dans la cavité 4. Cet appui, à la fois électrique et mécanique, est réalisé grâce à la forme particulière de l'organe de contact 6, et son effet est amplifié par la mise sous contrainte de cet organe 6 par un effort de compression exercé vers la platine 2, par la source d'énergie électrique 5.

Selon l'invention, appareil électronique portable comprend des moyens de maintien de la source d'énergie électrique 5 configurés pour être insérés dans la cavité 4 de façon à mettre en place la source d'énergie électrique 5 facilement tout en évitant un court-circuit.

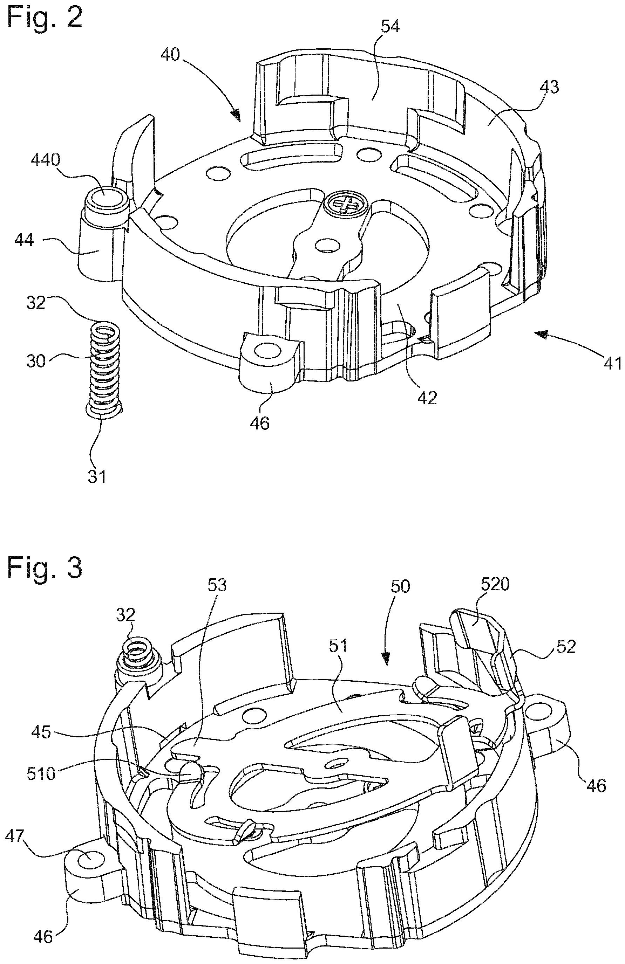

Comme on peut l'observer sur les figures 2 à 5, les moyens de maintien comprennent une cage amovible 41 en matière isolante présentant un fond 42 et une paroi circulaire 43 s'étendant depuis le fond 42 de manière à former un 40 agencé pour recevoir la source d'énergie électrique 5. Dans une version préférée mais non limitative de l'invention, la cage 41 est réalisée dans une matière plastique de manière à isoler la source d'énergie électrique 5 du module 1.

Selon une variante de l'invention, la cavité 4 peut être usinée à différents endroits sur la platine 2 en fonction du mouvement 7 choisi. En effet, la position des compteurs pouvant être modifiée en fonction des modèles, la position des moteurs peut aussi l'être, et il peut être nécessaire de déplacer l'usinage de la cavité 4 sans que cela ait une incidence pour la mise en place de la cage 41 au sein du module 1 sur la platine 2.

La cage 41 comprend également une bride amovible 50 pour maintenir la source d'énergie électrique 5 en place. La bride 50 comprend une partie centrale 51 de forme circulaire s'étendant sur le fond de la cage 41 et une partie latérale 52 s'étendant sur une partie de la paroi circulaire 43, la partie centrale 51 et la partie latérale 52 comprenant chacune au moins une lame ressort 510, 520 pour exercer respectivement un effort axial et un effort radial sur la source d'énergie de manière à maintenir la source d'énergie électrique 5 en place et empêcher cette dernière de tourner sur elle-même. La bride 50 peut être clippée dans la cage 41 par le biais de la partie latérale au moyen d'une partie complémentaire 54 formée sur la face intérieure de la paroi de la cage 41.

Selon un mode de réalisation préférentiel de l'invention, la bride 41 formée par la partie centrale 51 la partie latérale 52 est obtenue par un procédé d'étampage à partir d'une seule et même pièce réalisée dans un matériau conducteur comme le cuivre ou le laiton par exemple.

Les dimensions respectives de la source d'énergie électrique 5 et de la cage 41 sont telles que cette dernière est apte à recevoir la source d'énergie électrique 5, la face inférieure 501 de la source d'énergie électrique 5 venant en appui contre la partie centrale 51 de la bride 50 se trouvant au fond de la cage 41 et la tranche 502 de la source d'énergie électrique 5 venant en appui contre la partie latérale 52 de la bride et contre la surface interne de la paroi circulaire 43.

Selon l'invention, la bride est en contact avec le pôle positif de de la source d'énergie électrique 5 et l'organe de contact 6 est en contact avec pôle négatif de de la source d'énergie électrique 5. Bien évidemment, les deux pôles peuvent être inversés, la bride étant alors en contact avec le pôle négatif.

Les moyens de maintien comprennent également des moyens de contact pour assurer une liaison électrique entre le circuit imprimé 3 et la bride 50. Selon l'invention, les moyens de contact se présentent sous la forme d'un ressort 30 du type ressort hélicoïdal, et réalisé dans un matériau présentant une bonne conductivité électrique.

Tel que visible sur les figures 2 à 5, la cage 41 présente, sur la face extérieure de sa paroi 43, un logement tubulaire 44 s'étendant sur tout ou partie de la hauteur de la cage 41 et venant de matière avec la cage 41. Le logement tubulaire 44 comprend un trou traversant 440, de section circulaire, agencé pour recevoir le ressort 30, le ressort dépassant de part et d'autre de chacune des extrémités du logement tubulaire 44. Avantageusement, le ressort 63 présente une extrémité, dite base du ressort 31, plus large que le diamètre du trou traversant 440 de manière à former une butée et que le ressort 30 soit maintenu en place dans le logement 44, l'autre extrémité 32 du ressort dépassant du logement tubulaire 44.

De manière à assurer la liaison électrique entre le circuit imprimé 3 et la bride 50, la bride 50 comprend une languette 53 agencée pour être insérée dans une ouverture 45 à proximité immédiate du fond 42 de la cage 41 et débouchant au niveau de l'une des extrémités du logement 44 de manière que le ressort 30, et plus particulièrement la base 31 du ressort, soit en contact avec la languette 53 et le circuit imprimé 6 par chacune de ses extrémités.

De manière à maintenir la cage 41 en place sur le module 1 une fois la source d'énergie électrique 5 mise en place dans la cage, des moyens de fixation sont prévus à l'extérieur de la cage 41 pour fixer de manière amovible la cage 41 au module 1.

Tels que représentés sur les figures, les moyens de fixation sont matérialisés par des pattes de fixations 46, opposées l'une par rapport à l'autre, et présentant chacune un orifice 47 pour le passage d'une tige filetée destinée à être vissée dans le module 1.

La mise en place des moyens de maintien de la source d'énergie électrique 5 est réalisée comme suit.

Dans un premier temps, le ressort 30 est introduit dans le logement tubulaire 44, par le bas, au travers du trou traversant 440 de manière que la base 31 du ressort soit au même niveau que le fond de la cage 41, à proximité immédiate de l'ouverture 45. Ensuite la bride 50 est introduite en biais dans le logement 40 de la cage 41, en insérant en premier la languette 53 dans l'ouverture 45. La partie centrale 51 de la bride 50 est ensuite rabattue sur le fond 42 de la cage 41 et clippée dans cette dernière au moyen de partie latérale 52 de la bride 50, ce qui a pour effet de plaquer la languette 53 contre la base 31 du ressort 30 une fois la bride 50 clippée dans le logement 40.

L'introduction de la source d'énergie électrique 5 dans la cage 41 est effectuée par un positionnement de la face inférieure 501 de la source d'énergie électrique 5 face au fond 42 de la cage, suivi d'une pression exercée sur la face supérieure 503 de la source d'énergie électrique 5 en direction du fond 42 de la cage. Lors de cette opération, l'au moins une lame ressort 520 de la partie latérale 52 est repoussée par la face latérale 502 de la source d'énergie électrique 5 en direction de la paroi circulaire 43, ce qui entraîne une déformation élastique de la lame ressort 520, permettant ainsi un bon maintien radial de la source d'énergie électrique 5.

De plus, l'au moins une lame ressort 510 de la partie centrale 51 est repoussée en direction du fond 42 de la cage, ce qui entraîne une déformation élastique de la lame ressort 510 et permet ainsi un bon maintien axial de la source d'énergie électrique 5.

Une fois la source d'énergie électrique 5 engagée dans le logement 40 de la cage 41, cette dernière est mise en place dans la cavité 40 de manière à placer la face supérieure 503 contre l'organe de contact 8 et de manière à faire correspondre les pattes de fixation 46 avec des trous correspondants dans le module 1.

Lors de la mise en place de la cage 41, l'organe de contact 8 est repoussé vers la platine 2 et est mis sous contrainte, et l'extrémité 32 du ressort 30 est mise en contact avec le circuit imprimé 3 au niveau d'une zone de contact 33, ce qui permet d'assurer le contact électrique avec la source d'énergie électrique 5.

Par ailleurs, lors d'une opération de maintenance telle qu'un changement de la source d'énergie électrique 5, la maintenance est facilitée grâce à la structure ajourée de la cage 41 qui permet de faciliter l'extraction de la source d'énergie électrique 5. La structure ajourée de la cage 41 a également pour avantage de faciliter la circulation de l'air autour de la source d'énergie électrique 5.

Grâce à ces différents aspects de l'invention, on dispose d'un appareil électronique portable s'adaptant à plusieurs tailles de pile et différentes tailles de calibre. L'invention permet également de s'adapter à différentes position angulaires du mouvement, l'usinage pour former la cavité 4 pouvant être réalisé à différents endroits sur la platine 2. Par exemple, lorsque la position des compteurs est modifiée, la position des moteurs l'est aussi, et il suffit de déplacer l'usinage de la cavité 4 recevant la cage 41 sans avoir à concevoir une nouvelle pièce de maintien pour la source d'énergie électrique 5.

La description qui précède correspond à un mode de réalisation préféré et ne saurait en aucun cas être considérée comme limitative, en ce qui concerne plus particulièrement la forme décrite pour les différents éléments structurels composant le dispositif de montage ou leurs matériaux.

### NOMENCLATURE

1. Module,
2. Platine,
3. Circuit imprimé,
4. Cavité,
5. Source d'énergie électrique,
6. Organe de contact,
7. Mouvement,
30. Ressort,
31. Base du ressort,
32. Extrémité libre du ressort,
33. Zone de contact du circuit imprimé,
40. Logement,
41. Cage,
42. Fond de la cage,
43. Paroi de la cage,
44. Logement tubulaire,
440. Trou traversant,
45. Ouverture,
46. Pattes de fixation,
47. Orifice,
50. Bride,
51. Partie centrale de la bride,
52. Partie latérale de la bride,
53. Languette,
54. Partie complémentaire,
501. Face inférieure,
502. Face latérale,
503. Face supérieure,
510, 520. Lames ressort de la bride.

## Revendications

1. Appareil électronique portable comprenant au moins un module électronique (1), le module électronique comportant notamment une platine (2) munie d'une cavité (4) agencée pour recevoir une source d'énergie électrique (5), au moins un mouvement (7) associé à un circuit imprimé (3), un organe de contact (6) déformable élastiquement pour assurer une liaison électrique entre la source d'énergie électrique (5) et le circuit imprimé (3), et des moyens de maintien de la source d'énergie électrique (5),
**caractérisé en ce que** les moyens de maintien de la source d'énergie électrique (5) comprennent :
- une cage (41) amovible en matière isolante comprenant un fond (42) et une paroi circulaire (43), la cage (41) étant agencée pour recevoir la source d'énergie électrique (5) et comprenant une bride amovible (50) pour maintenir la source d'énergie électrique (5) en place, la cage (41) étant configurée pour être insérée dans la cavité (4),
- un ressort (30) pour assurer une liaison électrique entre le circuit imprimé (3) et la bride (50), et
- des moyens de fixation pour fixer de manière amovible la cage (41) au module (1).

2. Appareil électronique portable selon la revendication 1, dans lequel la bride (50) comprend une partie centrale (51) s'étendant sur le fond (42) de la cage (41) et une partie latérale (52) s'étendant sur une partie de la paroi circulaire (43), la partie centrale (42) et la partie latérale (43) comprenant chacune au moins une lame ressort (510 ; 520) pour exercer respectivement un effort axial et un effort radial sur la source d'énergie électrique (5).

3. Appareil électronique portable selon la revendication 1, dans lequel la paroi (43) de la cage (41) présente un logement (40) s'étendant sur tout ou partie de la hauteur de la cage (41) et qui est agencé pour recevoir le ressort (30), le ressort (30) dépassant de part et d'autre du logement (40).

4. Appareil électronique portable selon la revendication 3, dans lequel la bride (50) comprend une languette (53) agencée pour être insérée dans une ouverture (45) à proximité immédiate du fond (42) de la cage (41) et débouchant au niveau du logement (40) de manière que le ressort (30) soit en contact avec la languette (53) et le circuit imprimé (3).

5. Appareil électronique portable selon l'une quelconque des revendications 1 à 4, dans lequel la bride (50) est clippée dans la cage (41).

6. Appareil électronique portable selon l'une quelconque des revendications 1 à 5, dans lequel les moyens de fixation de la cage au module (1) comprennent des pattes de fixation (46) coopérant avec des moyens de vissage.

7. Appareil électronique portable selon l'une quelconque des revendications 1 à 6, dans lequel la cage (41) est réalisée en matière plastique.

8. Appareil électronique portable selon l'une quelconque des revendications 1 à 7, dans lequel l'organe de contact (6) est en contact avec le pôle négatif et la bride (50) est en contact avec le pôle positif.

## Patentansprüche

1. Tragbares elektronisches Gerät, umfassend mindestens ein elektronisches Modul (1), wobei das elektronische Modul insbesondere eine Platine (2) aufweist, die mit einem Hohlraum (4) versehen ist, der zur Aufnahme einer elektrischen Energiequelle (5), mindestens eines einer gedruckten Schaltung (3) zugeordneten Werks (7), eines Kontaktelements (6), das elastisch verformbar ist, um eine elektrische Verbindung zwischen der elektrischen Energiequelle (5) und der gedruckten Schaltung (3) bereitzustellen, und von Mitteln zum Halten der elektrischen Energiequelle (5) vorgesehen ist,
**dadurch gekennzeichnet, dass** die Mittel zum Halten der elektrischen Energiequelle (5) umfassen:
- einen abnehmbaren Käfig (41) aus Isoliermaterial, der einen Boden (42) und eine kreisförmige Wand (43) aufweist, wobei der Käfig (41) zur Aufnahme der elektrischen Energiequelle (5) angeordnet ist und einen abnehmbaren Flansch (50) zum Halten der elektrischen Energiequelle (5) an Ort und Stelle umfasst, wobei der Käfig (41) zum Einsatz in den Hohlraum (4) konfiguriert ist,
- eine Feder (30), um eine elektrische Verbindung zwischen der gedruckten Schaltung (3) und dem Flansch (50) bereitzustellen, und
- Befestigungsmittel zur lösbaren Befestigung des Käfigs (41) am Modul (1).

2. Tragbares elektronisches Gerät nach Anspruch 1, wobei der Flansch (50) einen mittleren Abschnitt (51), der sich auf dem Boden (42) des Käfigs (41) erstreckt, und einen seitlichen Abschnitt (52), der sich auf einem Teil der kreisförmigen Wand (43) erstreckt, umfasst, wobei der mittlere Abschnitt (42) und der seitliche Abschnitt (43) jeweils mindestens ein Federblatt (510; 520) zum Ausüben einer Axialkraft bzw. einer Radialkraft auf die elektrische Energiequelle (5) aufweisen.

3. Tragbares elektronisches Gerät nach Anspruch 1, wobei die Wand (43) des Käfigs (41) einen Aufnahmeraum (40) aufweist, der sich über die gesamte Höhe des Käfigs (41) oder einen Teil hiervon erstreckt und der zur Aufnahme der Feder (30) angeordnet ist, wobei die Feder (30) beiderseits des Aufnahmesitzes (40) übersteht.

4. Tragbares elektronisches Gerät nach Anspruch 3, wobei der Flansch (50) eine Zunge (53) aufweist, die so angeordnet ist, dass sie in eine Öffnung (45) in unmittelbarer Nähe des Bodens (42) des Käfigs (41), die in den Aufnahmeraum (40) führt, eingesetzt wird, derart, dass die Feder (30) mit der Zunge (53) und der gedruckten Schaltung (3) in Kontakt steht.

5. Tragbares elektronisches Gerät nach einem der Ansprüche 1 bis 4, wobei der Flansch (50) in den Käfig (41) eingeklipst ist.

6. Tragbares elektronisches Gerät nach einem der Ansprüche 1 bis 5, wobei die Mittel zum Befestigen des Käfigs an dem Modul (1) Befestigungslaschen (46) aufweisen, die mit Schraubmitteln zusammenwirken.

7. Tragbares elektronisches Gerät nach einem der Ansprüche 1 bis 6, wobei der Käfig (41) aus Kunststoff hergestellt ist.

8. Tragbares elektronisches Gerät nach einem der Ansprüche 1 bis 7, wobei das Kontaktelement (6) mit dem negativen Pol in Kontakt steht und der Flansch (50) mit dem positiven Pol in Kontakt steht.

## Claims

1. Portable electronic device comprising at least one electronic module (1), the electronic module comprising, in particular, a main plate (2) provided with a cavity (4) arranged for receiving an electrical energy source (5), at least one movement (7) associated with a printed circuit (3), an elastically deformable contact member (6) for ensuring an electrical connection between the electrical energy source (5) and the printed circuit (3), and means for holding the electrical energy source (5),
**characterized in that** the means for holding the electrical energy source (5) comprise:
- a removable holder (41) made of insulating material comprising a bottom (42) and a circular wall (43), the holder (41) being arranged to receive the electrical energy source (5) and comprising a removable clamp (50) for holding the electrical energy source (5) in place, the holder (41) being configured to be inserted inside the cavity (4),
- a spring (30) for ensuring an electrical connection between the printed circuit (3) and the clamp (50), and
- securing means for removably securing the holder (41) to the module (1).

2. Portable electronic device according to claim 1, wherein the clamp (50) comprises a central portion (51) extending over the bottom (42) of the holder (41) and a lateral portion (52) extending over one part of the circular wall (43), the central portion (42) and the lateral portion (43) each comprising at least one strip spring (510; 520) for respectively exerting an axial force and a radial force on the electrical energy source (5).

3. Portable electronic device according to claim 1, wherein the wall (43) of the holder (41) has a housing (40) extending over all or part of the top of the holder (41) and which is arranged to receive the spring (30), the spring (30) protruding from both sides of the housing (40).

4. Portable electronic device according to claim 3, wherein the clamp (50) comprises a tongue (53) arranged to be inserted in an aperture (45) in immediate proximity to the bottom (42) of the holder (41) and emerging in the housing (40) such that the spring (30) is in contact with the tongue (53) and the printed circuit (3).

5. Portable electronic device according to any of claims 1 to 4, wherein the clamp (50) is snapped into the holder (41).

6. Portable electronic device according to any of claims 1 to 5, wherein the means for securing the holder to the module (1) comprise securing lugs (46) cooperating with screw means.

7. Portable electronic device according to any of claims 1 to 6, wherein the holder (41) is made of plastic material.

8. Portable electronic device according to any of claims 1 to 7, wherein the contact member (6) is in contact with the negative pole and the clamp (50) is in contact with the positive pole.
